# EUROPEAN PATENT APPLICATION

(11) **EP 4 386 473 A1**
(43) Date of publication of application: **19.06.2024**
(21) Application number: 22863532.2
(22) Date of filing: 31.08.2022
(51) Int. Cl.: G02F 1/09, C30B 29/28, C30B 29/16

(54) **MAGNETO-OPTICAL THIN FILM, OPTICAL ISOLATOR, AND METHOD FOR MANUFACTURING MAGNETO-OPTICAL THIN FILM**

(30) Priority: 06.09.2021 CN 202111040113
(71) Applicant: Huawei Technologies Co., Ltd., Shenzhen, Guangdong 518129 (CN)
(72) Inventor: CHEN, Rong, Wuhan, Hubei 430074 (CN); CAO, Kun, Wuhan, Hubei 430074 (CN); XIONG, Yingfei, Wuhan, Hubei 430074 (CN); JIN, Zerui, Wuhan, Hubei 430074 (CN); ZHOU, Huajun, Wuhan, Hubei 430074 (CN); LI, Haohua, Shenzhen, Guangdong 518129 (CN); ZHANG, Bin, Shenzhen, Guangdong 518129 (CN)
(74) Representative: Pfenning, Meinig & Partner mbB
(86) International application number: PCT/CN2022/116269
(87) International publication number: WO 2023/030397

(57) **Abstract**

A magneto-optic thin film, an optical isolator, and a method for manufacturing a magneto-optic thin film are disclosed. The magneto-optic thin film includes: a substrate; a diffusion barrier layer disposed on the substrate, where the diffusion barrier layer includes a metal oxide; a buffer layer disposed on the diffusion barrier layer; and an optical isolation layer disposed on the buffer layer. In this embodiment, the metal oxide in the diffusion barrier layer growing on the substrate is polycrystalline. This better facilitates nucleation of the buffer layer on the diffusion barrier layer, and achieves good crystallinity. In addition, the metal oxide has high density and thermal stability, and therefore can provide stable and reliable diffusion barrier effect. This further reduces optical loss of the magneto-optic thin film.

## Description

This application claims priority to Chinese Patent Application No. 202111040113.0, filed on September 6, 2021 and entitled "MAGNETO-OPTIC THIN FILM, OPTICAL ISOLATOR, AND METHOD FOR MANUFACTURING MAGNETO-OPTIC THIN FILM", which is incorporated herein by reference in its entirety.

### TECHNICAL FIELD

Embodiments of this application relate to the field of magneto-optic thin film material technologies, and more specifically, to a magneto-optic thin film, an optical isolator, and a method for manufacturing a magneto-optic thin film.

### BACKGROUND

An optical isolator is an optical element that enables light to be transmitted in one direction without being transmitted in a reverse direction. For example, after the optical isolator is disposed at an emergent end of a semiconductor laser, light emitted by the laser passes through the optical isolator, and the optical isolator can be used as a light source for optical communication. On the contrary, incident light to be transmitted to the semiconductor laser through the optical isolator is blocked by the optical isolator, and cannot reach the semiconductor laser. If no optical isolator is disposed at the emergent end of the semiconductor laser, reflected light reaches the semiconductor laser. Consequently, an oscillation characteristic of the semiconductor laser deteriorates, output intensity changes (intensity noise is generated), an oscillation wavelength changes (phase noise is generated), and so on. In addition to the semiconductor laser, for active elements such as an optical amplifier, unexpected reverse incident light also causes degradation of operation characteristics of the active elements. Therefore, the optical isolator needs to be disposed at an output end of the semiconductor laser or the active element, to avoid the foregoing unexpected phenomena on the semiconductor laser or the active element. Especially when the semiconductor laser is used as a light source for high-speed fiber-optic communication, oscillation stability of the light source is an absolute condition. Therefore, the optical isolator needs to be used.

A yttrium iron garnet (YIG) magneto-optic material has a high optical rotation coefficient, high saturation magnetization intensity, a large Faraday rotation angle, and the like, and is currently a main magneto-optic material for implementing an optical isolation function in the optical isolator. However, it is difficult to integrate the YIG material with a semiconductor chip due to major problems such as a lattice mismatch and a thermal mismatch between the YIG material and a silicon substrate. Therefore, the YIG material is doped with rare earth elements (for example, doped with cerium ions Ce³⁺), so that magneto-optic performance can be further improved. In addition, a high-quality magneto-optic thin film can be prepared on a substrate by using a pulse laser deposition technology, to lay a good foundation for device integration. However, a conventional magneto-optic thin film preparation process has problems such as poor crystallinity and complex steps. This increases optical loss of the magneto-optic thin film, and hinders development of a monolithic integrated optical isolator.

### SUMMARY

Embodiments of this application provide a magneto-optic thin film, an optical isolator, and a method for manufacturing a magneto-optic thin film, to resolve the foregoing problems and other potential problems of a conventional magneto-optic thin film.

According to a first aspect of this application, a magneto-optic thin film is provided, including: a substrate; a diffusion barrier layer disposed on the substrate, where the diffusion barrier layer includes a metal oxide; a buffer layer disposed on the diffusion barrier layer; and an optical isolation layer disposed on the buffer layer. In this embodiment, the metal oxide in the diffusion barrier layer growing on the substrate is polycrystalline. This better facilitates nucleation of the buffer layer on the diffusion barrier layer, and achieves good crystallinity. In addition, the metal oxide has high density and thermal stability, and therefore can provide stable and reliable diffusion barrier effect. This further reduces optical loss of the magneto-optic thin film.

In some embodiments, the metal oxide includes at least one of magnesium oxide (MgO) and zinc oxide (ZnO). In this an embodiment, the MgO and/or the ZnO in the diffusion barrier layer have high density and thermal stability, and therefore can provide stable and reliable diffusion barrier effect. This further reduces optical loss of the magneto-optic thin film.

In some embodiments, a thickness of the diffusion barrier layer is less than 10 nm.

In some embodiments, the thickness of the diffusion barrier layer is within a range of 3 nm to 8 nm.

In some embodiments, the substrate includes at least one of silicon (Si), silicon-on-insulator (SOI), and silicon nitride (SiN).

In some embodiments, the buffer layer includes yttrium iron garnet (YIG).

In some embodiments, a thickness of the buffer layer is within a range of 90 nm to 110 nm.

In some embodiments, the optical isolation layer includes rare earth-doped yttrium iron garnet.

In some embodiments, the rare earth-doped yttrium iron garnet includes cerium-doped yttrium iron garnet (Ce:YIG).

According to a second aspect of this application, an optical isolator is provided, including the magneto-optic thin film according to the first aspect of this application.

According to a third aspect of this application, a method for manufacturing a magneto-optic thin film is provided. The method includes: step 1: depositing a diffusion barrier layer on a substrate, where the diffusion barrier layer includes a metal oxide; step 2: depositing a buffer layer including yttrium iron garnet (YIG) on the diffusion barrier layer; step 3: placing the film layer obtained in step 2 in a deposition cavity for in-situ annealing, injecting oxygen with an atmospheric pressure of 0.01 Pa to 10 Pa, increasing temperature to 600°C to 800°C, holding the temperature for 3 to 5 minutes, and waiting for natural cooling to room temperature; and step 4: placing the film layer obtained in step 3 at 650°C to 700°C in an oxygen atmosphere in which partial pressure of oxygen is 0 mTorr to 100 mTorr, and depositing an optical isolation layer including cerium-doped yttrium iron garnet (Ce:YIG) to obtain the magneto-optic thin film.

In some embodiments, the metal oxide includes at least one of (MgO) and zinc oxide (ZnO).

In some embodiments, a thickness of the diffusion barrier layer is less than 10 nm.

In some embodiments, the thickness of the diffusion barrier layer is within a range of 3 nm to 8 nm.

In some embodiments, the substrate includes at least one of silicon (Si), silicon-on-insulator (SOI), and silicon nitride (SiN).

In some embodiments, a thickness of the buffer layer is within a range of 90 nm to 110 nm.

The summary is provided to describe selection of concepts in a simplified form, and the concepts are further described in the following specific implementations. The summary is not intended to indicate key features or main features of content of this application or limit the scope of the content of this application.

### BRIEF DESCRIPTION OF DRAWINGS

The foregoing and other objectives, features, and advantages of embodiments of this application are easier to understand by reading the following detailed descriptions with reference to accompanying drawings. In the accompanying drawings, several embodiments of this application are shown as examples rather than limitations.
FIG. 1 is a schematic diagram of a magneto-optic thin film according to an embodiment of this application;
FIG. 2 shows effect of diffusion barrier layers with different thicknesses on crystallinity in an X-ray diffraction (XRD) diagram;
FIG. 3 shows comparison between a Faraday rotation angle of a magneto-optic thin film including an MgO diffusion barrier layer and a Faraday rotation angle of a magneto-optic thin film not including an MgO diffusion barrier layer;
FIG. 4 shows comparison between a Faraday rotation angle, obtained before an aging test is performed, of a magneto-optic thin film including an MgO diffusion barrier layer and a Faraday rotation angle obtained after an aging test is performed;
FIG. 5 shows comparison between transmittance of a magneto-optic thin film including an MgO diffusion barrier layer and transmittance of a magneto-optic thin film not including an MgO diffusion barrier layer;
FIG. 6 shows comparison between a refractive index of a magneto-optic thin film including an MgO diffusion barrier layer and a refractive index of a magneto-optic thin film not including an MgO diffusion barrier layer, and comparison between an extinction coefficient of the magneto-optic thin film including the MgO diffusion barrier layer and an extinction coefficient of the magneto-optic thin film not including an MgO diffusion barrier layer;
FIG. 7 shows surface morphology of YIG grains captured by an atomic force microscope; and
FIG. 8 shows surface morphology of Ce:YIG captured by an atomic force microscope.

In the accompanying drawings, same or corresponding reference numerals indicate same or corresponding parts.

### DESCRIPTION OF EMBODIMENTS

The following describes technical solutions of this application with reference to accompanying drawings. Clearly, the described embodiments are merely some but not all of embodiments of this application.

In descriptions of embodiments of this application, "/" indicates "or", unless otherwise specified. For example, A/B may indicate A or B. The term "and/or" in this specification describes only an association relationship between associated objects, and indicates that three relationships may exist. For example, A and/or B may indicate the following three cases: Only A exists, both A and B exist, and only B exists.

Terms such as "first" and "second" mentioned below are merely intended for a purpose of description, and shall not be understood as an indication or implication of relative importance or an implicit indication of a quantity of indicated technical features. Therefore, a feature limited by "first", "second", or the like may explicitly or implicitly include one or more features.

In addition, in this application, orientation terms such as "center", "front", "rear", "inside", and "outside" are defined relative to orientations or positions of components shown in the accompanying drawings. It should be understood that these directional terms are relative concepts and are used for relative description and clarification, but not to indicate or imply that an indicated apparatus or component needs to have a specific orientation or be constructed or operated in a specified orientation. The terms may vary correspondingly based on changes of the orientations in which the components in the accompanying drawings are placed, and therefore cannot be construed as a limitation on this application.

It should be further noted that, in embodiments of this application, a same reference numeral indicates a same component or a same part. For same parts in embodiments of this application, only one part or component marked with a reference numeral may be used as an example in the figures. It should be understood that the reference numeral is also applicable to another same part or component.

In a previously proposed two-step deposition method, optical loss of a cerium-doped yttrium iron garnet (Ce:YIG) thin film prepared by using a YIG thin film as a seed layer varies greatly with different processes, and loss of an obtained magneto-optic material is quite high, and may be higher than 20 dB. Direct deposition of the YIG/Ce:YIG thin film on a silicon substrate mainly has the following problems: (1) Because the YIG seed layer is in direct contact with the silicon substrate, magneto-optic performance and optical loss of the seed layer greatly affect performance of an entire device. Currently, a YIG thin film with a thickness of approximately 20 nanometers is usually used as a seed layer for growing a Ce:YIG thin film. Different growth processes lead to a great difference in device performance and loss. (2) Silicon elements in the silicon substrate diffuse toward the YIG/Ce:YIG thin film during high-temperature deposition, and an impurity phase is finally formed. Consequently, a magneto-optic crystal structure is incomplete, magneto-optic performance is degraded, and loss increases.

Therefore, research on a process for integrating a magneto-optic material such as polycrystalline Ce:YIG on a silicon substrate, and research on an optical loss mechanism of a material and factors affecting magneto-optic performance are of great significance for improving a magneto-optic figure of merit of a material and developing a low-loss silicon-based optical isolator. In this application, a diffusion barrier layer including a metal oxide layer is deposited on a substrate to prevent mutual diffusion between a subsequently grown YIG layer and Ce:YIG and the substrate, so as to reduce optical loss and further improve crystallinity of the YIG layer and isolation performance of a magneto-optic thin film.

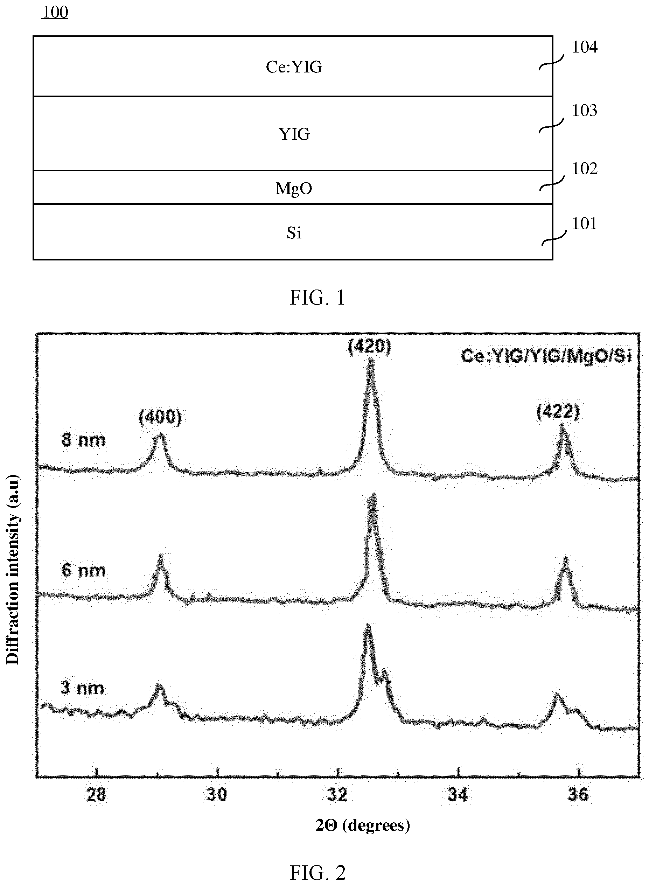

FIG. 1 is a schematic diagram of a magneto-optic thin film 100 according to an embodiment of this application. As shown in FIG. 1, the magneto-optic thin film 100 described herein includes a substrate 101, a diffusion barrier layer 102 disposed on the substrate 101, a buffer layer 103 disposed on the diffusion barrier layer 102, and an optical isolation layer 104 disposed on the buffer layer 103. In the embodiment shown in FIG. 1, the substrate 101 is made of silicon, the diffusion barrier layer 102 is made of MgO, the buffer layer 103 is made of YIG, and the optical isolation layer 104 is made of Ce:YIG. The optical isolation layer 104 made of the Ce:YIG is configured to isolate light through magneto-optic effect, so that light can be transmitted in the substrate 104 only unidirectionally. The buffer layer 103 made of the YIG is configured to alleviate lattice mismatch and thermal mismatch problems between the Ce:YIG and the substrate 101. The diffusion barrier layer 102 made of the MgO is configured to prevent mutual diffusion between the substrate 101, the buffer layer 103, and the optical isolation layer 104.

The inventor finds that, when a nonmetallic oxide such as silicon dioxide (SiO₂) is used as the diffusion barrier layer 102, because SiO₂ is amorphous, crystallinity of the YIG on the SiO₂ layer is poor. Consequently, an obtained magneto-optic thin film still has high optical loss. In addition, the inventor finds through an experiment that, when the MgO is used as the diffusion barrier layer 102, because the deposited MgO is polycrystalline, this is more conducive to nucleation of the YIG on the diffusion barrier layer 102, and crystallinity is good, so that surface roughness of a device can be reduced, to reduce loss and increase a Faraday rotation angle. In addition, compared with the SiO₂, the MgO has higher density and thermal stability, and therefore can provide stable and reliable diffusion barrier effect. This further reduces optical loss of the magneto-optic thin film.

In some embodiments, a thickness of the diffusion barrier layer 102 may be less than 10 nm, for example, within a range of 3 nm to 8 nm, for example, 3 nm, 6 nm, or 8 nm. It should be understood that, in this embodiment of this application, the diffusion barrier layer 102 may have a larger or smaller thickness. This is not strictly limited in the scope of this application.

In some embodiments, loss of a YIG thin film material in the deposited buffer layer 103 can be adjusted by adjusting a thickness of the YIG thin film material. The inventor finds through an experiment that, when the thickness of the thin film is excessively small, crystallization of the YIG thin film is incomplete, scattering loss of the material is high, a limiting factor is small, and a large device length is required; and when the thickness of the thin film is large, a limiting factor of a mode in the YIG increases, leading to high total loss of a waveguide. The inventor finds that the scattering loss of the material is low when a thickness of the buffer layer 103 is within a range of 90 nm to 110 nm.

A layer of MgO is deposited on the substrate 101 as the diffusion barrier layer 102, to prevent mutual diffusion between the subsequently grown YIG and Ce:YIG thin film materials and the Si in the substrate 101, without affecting crystallinity of the YIG and Ce:YIG materials or mode field distribution of the device. In addition, loss can be reduced by selecting a buffer layer 103 that includes YIG and that has a thickness of 90 nm to 110 nm. In this manner, the finally prepared magneto-optic thin film 100 can achieve maximum saturation magnetization intensity of approximately 110 emu/cm³. After doping of a target material, a preparation process for the target material, and a preparation process for a thin film are optimized, a Faraday rotation angle of a target material with a doping concentration X of 2 is approximately 4300°/cm. This greatly helps improve a magneto-optic figure of merit of a material and develop a low-loss silicon-based optical isolator.

In the foregoing descriptions, the substrate 101 including the silicon is used as an example to describe the principle of this application. However, it should be understood that, in another embodiment, the substrate 101 may include another substrate material that is known or is available in the future, for example, silicon-on-insulator (SOI) or silicon nitride (SiN). In addition, the substrate 101 may include only one substrate material, or may include a plurality of substrate materials. This is not strictly limited in the scope of this application.

In some embodiments, a metal oxide in the diffusion barrier layer 102 may include zinc oxide (ZnO), instead of the MgO. Similar to the MgO, the deposited ZnO is polycrystalline. Therefore, this is more conducive to nucleation of the YIG on the diffusion barrier layer 102, and crystallinity is good. In addition, compared with the SiO₂, the ZnO has higher density and thermal stability, and therefore can provide stable and reliable diffusion barrier effect. This further reduces optical loss of the magneto-optic thin film.

In some embodiments, the metal oxide in the diffusion barrier layer 102 may include both MgO and ZnO, instead of only the MgO or the ZnO. This also facilitates nucleation of the YIG on the diffusion barrier layer 102, and can provide stable and reliable diffusion barrier effect, and reduce optical loss of the magneto-optic thin film.

It should be understood that, in this embodiment of this application, the diffusion barrier layer 102 may include another metal compound with high density and thermal stability. This also facilitates nucleation of the YIG on the diffusion barrier layer 102, and can provide stable and reliable diffusion barrier effect, and reduce optical loss of the magneto-optic thin film.

In the foregoing descriptions, the buffer layer 103 including the YIG is used as an example to describe the principle of this application. However, it should be understood that, in another embodiment, the buffer layer 103 may include another buffer layer material that is known or that is available in the future. This is not strictly limited in the scope of this application.

In the foregoing descriptions, the optical isolation layer 104 including the Ce:YIG is used as an example to describe a principle of this application. However, it should be understood that, in another embodiment, the optical isolation layer 104 may include other rare earth-doped yttrium iron garnet. This is not strictly limited in the scope of this application.

The magneto-optic thin film 100 described in this embodiment of this application may be used in an optical isolator, so that light can be transmitted in the optical isolator only along a single direction.

An embodiment of this application further provides a method for manufacturing a magneto-optic thin film, including the following steps: Step 1: Deposit a diffusion barrier layer on a substrate, where the diffusion barrier layer includes a metal oxide, for example, MgO and/or ZnO, or another material, and is intended to prevent mutual diffusion between the subsequently grown YIG and Ce:YIG and the substrate, without affecting crystallinity of YIG and Ce:YIG materials or mode field distribution of a device. Step 2: Deposit a buffer layer including YIG on the diffusion barrier layer, where a thickness of the buffer layer is, for example, within a range of 90 nm to 110 nm. Step 3: Place the film layer obtained in step 2 in a deposition cavity for in-situ annealing, inject oxygen with an atmospheric pressure of 0.01 Pa to 10 Pa (for example, 0.01 Pa, 0.1Pa, or 10Pa), increase temperature to 600°C to 800°C, hold the temperature for 3 to 5 minutes, and wait for natural cooling to room temperature. Step 4: Place the film layer obtained in step 3 at 650°C to 700°C in an oxygen atmosphere in which partial pressure of oxygen is 0 mTorr to 100 mTorr, and deposit an optical isolation layer including Ce:YIG to obtain a magneto-optic thin film.

The inventor finds through an experiment that, in step 2, when the thickness of the YIG thin film material is excessively small, crystallization of the YIG thin film is incomplete, scattering loss of the material is high, a limiting factor is small, and a large device length is required; and when the thickness of the thin film is large, a limiting factor of a mode in the YIG increases, leading to high total loss of a waveguide. The inventor finds that the scattering loss of the material is low when a thickness of the buffer layer 103 is within a range of 90 nm to 110 nm.

In step 4, a reason for preparation by using different partial pressure of oxygen is as follows: At low partial pressure of oxygen, there are many Fe²⁺ ions in the Ce:YIG thin film, and material loss is high; and at high partial pressure of oxygen, Ce³⁺ ions in the Ce:YIG thin film are oxidized into Ce⁴⁺, magneto-optic effect of the thin film is degraded, a device length increases, and loss increases.

In this embodiment of this application, the MgO or the like is used as the diffusion barrier layer. This can improve crystallinity of a subsequently deposited thin film, and can also alleviate thermal stress mismatch, to prevent performance degradation due to stress mismatch between the YIG and the Ce:YIG. The thickness of the buffer layer has little impact on magnetization intensity of the magneto-optic thin film, but greatly affects an external magnetic field required for achieving saturation magnetization intensity.

A layer of MgO is deposited on the substrate as the diffusion barrier layer, to prevent mutual diffusion between the subsequently grown YIG and Ce:YIG thin films and Si in the substrate, without affecting crystallinity of the YIG and Ce:YIG materials or mode field distribution of the device. In addition, loss can be reduced by selecting a YIG thin film with a thickness of 90 nm to 110 nm.

In some embodiments, a thickness of the diffusion barrier layer is less than 10 nm.

In some embodiments, the thickness of the diffusion barrier layer is within a range of 3 nm to 8 nm.

In some embodiments, the substrate includes at least one of silicon (Si), silicon-on-insulator (SOI), and silicon nitride (SiN).

FIG. 2 shows effect of diffusion barrier layers with different thicknesses on crystallinity in an X-ray diffraction (XRD) diagram. As shown in FIG. 2, when the thickness of the MgO diffusion barrier layer increases from 3 nm to 8 nm, diffraction intensity gradually increases. When the thickness of the MgO diffusion barrier layer is 8 nm, a peak of the diffraction intensity is the purest, peak intensity is strong, and a peak width at half height is narrow. This indicates that, in this case, crystallinity of the YIG and Ce:YIG material layers is good, and optical loss of the material is low.

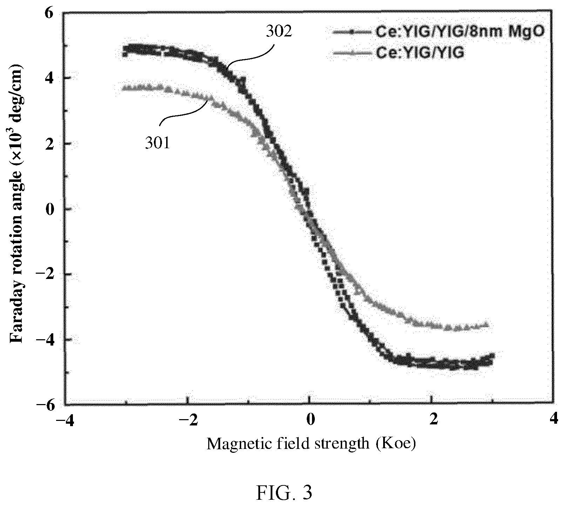

FIG. 3 shows comparison between a Faraday rotation angle of a magneto-optic thin film including an MgO diffusion barrier layer and a Faraday rotation angle of a magneto-optic thin film not including an MgO diffusion barrier layer. A curve 301 indicates the Faraday rotation angle of the magneto-optic thin film not including an MgO diffusion barrier layer. A curve 302 indicates the Faraday rotation angle of the magneto-optic thin film including the MgO diffusion barrier layer. As shown in FIG. 3, compared with the magneto-optic thin film not including an MgO diffusion barrier layer, the magneto-optic thin film including the MgO diffusion barrier layer has a significantly larger Faraday rotation angle, and this magneto-optic thin film has smaller optical loss.

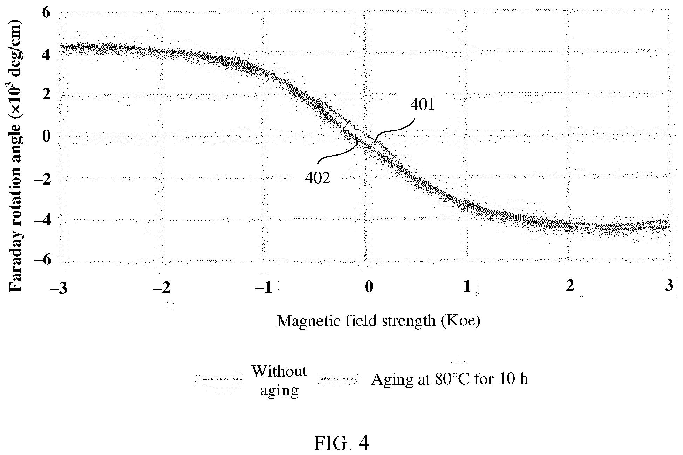

FIG. 4 shows comparison between a Faraday rotation angle, obtained before an aging test is performed, of a magneto-optic thin film including an MgO diffusion barrier layer and a Faraday rotation angle obtained after an aging test is performed. A curve 401 indicates the Faraday rotation angle, obtained before the aging test is performed, of the magneto-optic thin film including the MgO diffusion barrier layer. A curve 402 indicates the Faraday rotation angle, obtained after the aging test is performed (for example, at 80°C for 10 hours), of the magneto-optic thin film including the MgO diffusion barrier layer. As shown in FIG. 4, the curve 401 is basically consistent with the curve 402. This indicates that, compared with the Faraday rotation angle obtained before the aging test is performed, the Faraday rotation angle obtained after the aging test is performed on an 8-nm diffusion barrier layer at 80°C for 10 hours does not deteriorate.

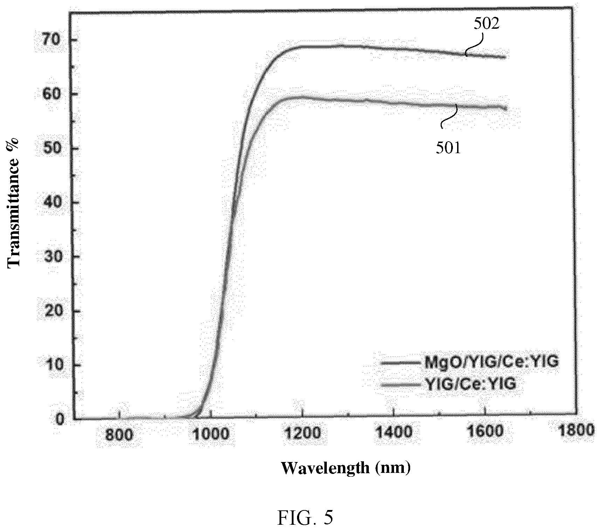

FIG. 5 shows comparison between transmittance of a magneto-optic thin film including an MgO diffusion barrier layer and transmittance of a magneto-optic thin film not including an MgO diffusion barrier layer. A curve 501 indicates the transmittance of the magneto-optic thin film not including an MgO diffusion barrier layer. A curve 502 indicates the transmittance of the magneto-optic thin film including the MgO diffusion barrier layer. As shown in FIG. 5, when a wavelength is greater than 1000 nm (especially, greater than 1100 nm), the transmittance of the magneto-optic thin film including the MgO diffusion barrier layer is greater than the transmittance of the magneto-optic thin film not including an MgO diffusion barrier layer. Therefore, the magneto-optic thin film including the MgO diffusion barrier layer can provide higher optical performance.

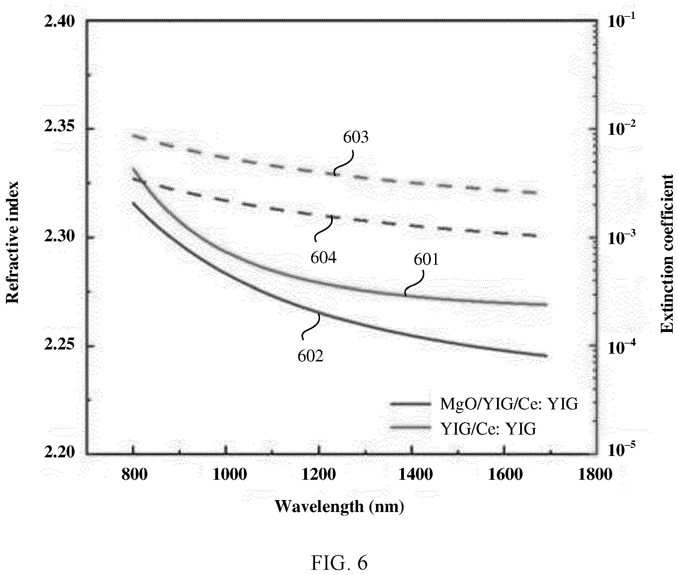

FIG. 6 shows comparison between a refractive index of a magneto-optic thin film including an MgO diffusion barrier layer and a refractive index of a magneto-optic thin film not including an MgO diffusion barrier layer, and comparison between an extinction coefficient of the magneto-optic thin film including the MgO diffusion barrier layer and an extinction coefficient of the magneto-optic thin film not including an MgO diffusion barrier layer. A curve 601 indicates the refractive index of the magneto-optic thin film not including an MgO diffusion barrier layer. A curve 602 indicates the refractive index of the magneto-optic thin film including the MgO diffusion barrier layer. A curve 603 indicates the extinction coefficient of the magneto-optic thin film not including an MgO diffusion barrier layer. A curve 604 indicates the extinction coefficient of the magneto-optic thin film including the MgO diffusion barrier layer. As shown in FIG. 6, compared with the magneto-optic thin film not including an MgO diffusion barrier layer, the magneto-optic thin film including the MgO diffusion barrier layer has a smaller refractive index and extinction coefficient.

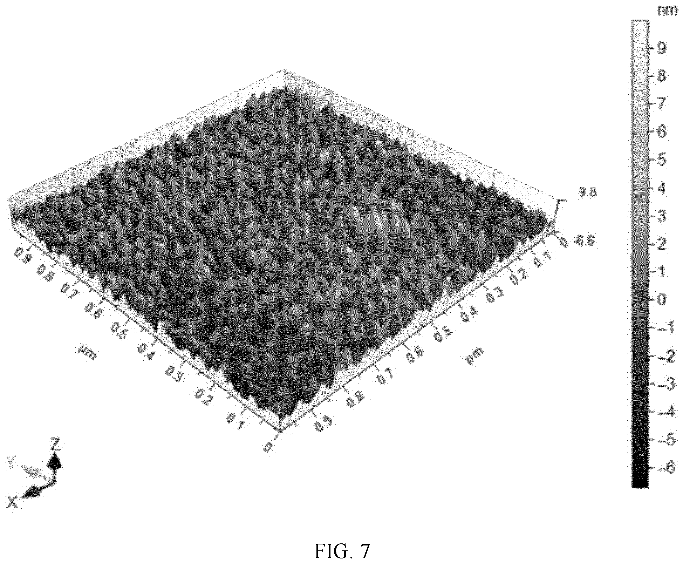

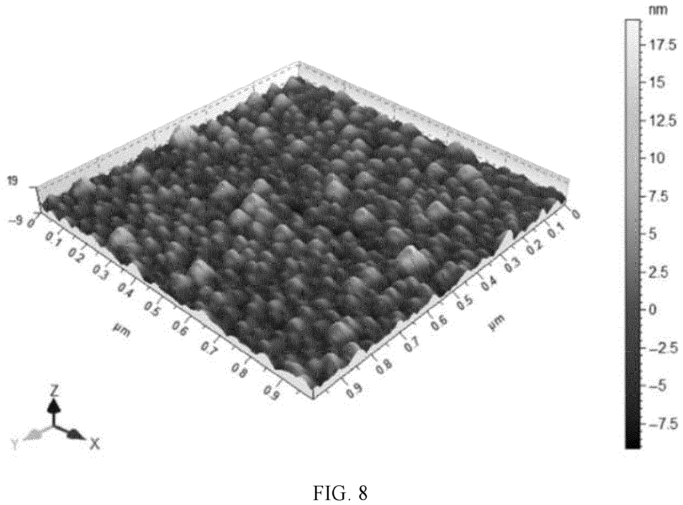

FIG. 7 shows surface morphology of YIG grains captured by an atomic force microscope. FIG. 8 shows surface morphology of Ce:YIG captured by an atomic force microscope. As shown in FIG. 7 and FIG. 8, after an MgO diffusion barrier layer is deposited, YIG grains are small, nucleation sites are uniform, and most of the nucleation sites face upward. This facilitates preferred orientation of Ce:YIG and achieves good crystallinity.

Embodiments of this application are described above. The foregoing descriptions are examples but are not exhaustive, and are not limited to the disclosed embodiments. Many modifications and variations are clear to a person of ordinary skill in the art without departing from the scope and spirit of the described embodiments. Selection of terms used in this specification is intended to best explain principles and practical applications of embodiments or improvements made to technologies on the market, or to enable a person of ordinary skill in the art to understand embodiments disclosed in this specification.

## Claims

1. A magneto-optic thin film, comprising:
a substrate;
a diffusion barrier layer disposed on the substrate, wherein the diffusion barrier layer comprises a metal oxide;
a buffer layer disposed on the diffusion barrier layer; and
an optical isolation layer disposed on the buffer layer.

2. The magneto-optic thin film according to claim 1, wherein the metal oxide comprises at least one of magnesium oxide (MgO) and zinc oxide (ZnO).

3. The magneto-optic thin film according to claim 2, wherein a thickness of the diffusion barrier layer is less than 10 nm.

4. The magneto-optic thin film according to claim 3, wherein the thickness of the diffusion barrier layer is within a range of 3 nm to 8 nm.

5. The magneto-optic thin film according to claim 1, wherein the substrate comprises at least one of silicon (Si), silicon-on-insulator (SOI), and silicon nitride (SiN).

6. The magneto-optic thin film according to claim 1, wherein the buffer layer comprises yttrium iron garnet (YIG).

7. The magneto-optic thin film according to claim 6, wherein a thickness of the buffer layer is within a range of 90 nm to 110 nm.

8. The magneto-optic thin film according to claim 6, wherein the optical isolation layer comprises rare earth-doped yttrium iron garnet.

9. The magneto-optic thin film according to claim 8, wherein the rare earth-doped yttrium iron garnet comprises cerium-doped yttrium iron garnet (Ce:YIG).

10. An optical isolator, comprising the magneto-optic thin film according to any one of claims 1 to 9.

11. A method for manufacturing a magneto-optic thin film, wherein the method comprises:
step 1: depositing a diffusion barrier layer on a substrate, wherein the diffusion barrier layer comprises a metal oxide;
step 2: depositing a buffer layer comprising yttrium iron garnet (YIG) on the diffusion barrier layer;
step 3: placing the film layer obtained in step 2 in a deposition cavity for in-situ annealing, injecting oxygen with an atmospheric pressure of 0.01 Pa to 10 Pa, increasing temperature to 600°C to 800°C, holding the temperature for 3 to 5 minutes, and waiting for natural cooling to room temperature; and
step 4: placing the film layer obtained in step 3 at 650°C to 700°C in an oxygen atmosphere in which partial pressure of oxygen is 0 mTorr to 100 mTorr, and depositing an optical isolation layer comprising cerium-doped yttrium iron garnet (Ce:YIG) to obtain the magneto-optic thin film.

12. The method according to claim 11, wherein the metal oxide comprises at least one of (MgO) and zinc oxide (ZnO).

13. The method according to claim 12, wherein a thickness of the diffusion barrier layer is less than 10 nm.

14. The method according to claim 13, wherein the thickness of the diffusion barrier layer is within a range of 3 nm to 8 nm.

15. The method according to claim 11, wherein the substrate comprises at least one of silicon (Si), silicon-on-insulator (SOI), and silicon nitride (SiN).

16. The method according to claim 11, wherein a thickness of the buffer layer is within a range of 90 nm to 110 nm.
